# EUROPEAN PATENT APPLICATION

(11) **EP 1 241 779 A2**
(43) Date of publication of application: **18.09.2002**
(21) Application number: 01309127.7
(22) Date of filing: 26.10.2001
(51) Int. Cl.: H03C 3/00, H03D 7/16

(54) **Receiver used in multi-carrier reception**

(30) Priority: 07.03.2001 US 801433
(71) Applicant: Nokia Corporation, 02150 Espoo (FI)
(72) Inventor: Haapoja, Sami, 00810 Helsinki (FI); Hamalainen, Mikka, 02230 Espoo (FI)
(74) Representative: Walaski, Jan Filip

(57) **Abstract**

In accordance with a method for single-carrier and multi-carrier reception, the following steps are executed: downconverting a received RF signal to in-phase (I) and quadrature (Q) channel signals each containing a plurality of sub-carriers at a low intermediate frequency (low-IF) and, if required, one sub-carrier or a single carrier centered around 0 Hz; filtering interfering signals outside of a frequency band of interest with analog lowpass filters in the I and Q channels; converting the I and Q channel signals to digital representations thereof; in the multi-carrier reception case, separating sub-carriers that are images of one another by quadrature downmixing the digital representations of the I and Q channel signals to baseband in the digital domain; and digitally adding or subtracting resulting I and Q signals to obtain one or both of an upper sideband and a lower sideband containing desired ones of the multi-carriers. For a symmetric multi-carrier reception case the step of downconverting includes a step of tuning a local oscillator to a center frequency of a group of sub-carriers, while for an asymmetric multi-carrier reception case the step of downconverting includes a step of tuning a local oscillator between a middlemost sub-carrier and its interfering adjacent channel.

## Description

### FIELD OF THE INVENTION:

This invention relates generally to wireless communications systems and methods and, more specifically, relates to RF receivers capable of receiving multiple carrier frequencies (multi-carriers).

### BACKGROUND OF THE INVENTION:

Modern wireless telecommunications systems are evolving to provide high speed packet data services for users of mobile equipment. One example is an ability to provide internet access to a user of mobile equipment. One wireless system that is rapidly evolving in this direction is a Time Division, Multiple Access (TDMA) system known as the Global System for Mobile Communication (GSM), in particular enhanced versions of GSM known as GSM+, GPRS (General Packet Radio Services) and EGPRS (Enhanced General Packet Radio Services).

As such modern wireless communication system evolve it is inevitable that user demand will increase for higher speed data connections. One particularly attractive technique for increasing the effective data rate is to provide a multi-carrier transmission capability for the wireless network, as well as a corresponding multi-carrier reception capability for the wireless equipment, also referred to herein as a mobile station. In this type of system each carrier could convey a separate data stream, or different parts of a single data stream, thereby effectively increasing the aggregate data rate that is received by the mobile station. For the purposes of this invention a mobile station could be a handheld or vehicle-installed cellular telephone, a personal communicator, a personal digital assistant (PDA) type of device having wireless communication capabilities, a personal computer (PC) with wireless communication capabilities, as well as other types of devices having a wireless communication capability.

An important consideration when implementing a multi-carrier reception capability in the mobile station is that it does not adversely impact the integration level, cost, power consumption and complexity of the mobile station. Another consideration is that the inclusion of multi-carrier reception capability does not compromise the ability of the receiver to operate in a normal, single carrier environment.

A number of approaches to providing multi-carrier reception capability presently exist. However, and as will be shown below, none of these approaches provides an optimum solution.

It is first noted that it can be shown for a number of practical reasons that the use of a direct conversion receiver (DCRX) is preferred for implementing a multi-carrier receiver. In the DCRX approach the received RF carrier is downconverted directly to baseband, thereby avoiding the generation of one or more intermediate frequencies (IFs). Reference with regard to DCRX can be had, for example, to the following commonly assigned U.S. Patents, which are incorporated by reference herein in their entireties: U.S. Patent No.: 6,115,593, "Elimination of D.C. Offset and Spurious AM Suppression in a Direct Conversion Receiver", by Petteri Alinikula et al.; U.S. Patent No.: 5,983,081, "Method for Generating Frequencies in a Direct Conversion Transceiver of a Dual Band Radio Communication System, a Direct Conversion Transceiver of a Dual Band Radio Communication System and the Use of this Method and Apparatus in a Mobile Station", by Kari Lehtinen; and U..S. Patent No.: 5,896,562, "Transmitter/Receiver for Transmitting and Receiving of an RF Signal in Two Frequency Bands", by Jarmo Heinonen.

A first potential multi-carrier reception technique can be referred to as analog downconversion. In this system a DCRX chain is provided, for each carrier, from in-phase (I) and quadrature (Q) mixers to analog to digital converters (ADCs). However, the use of this approach would require a substantial increase in the required power consumption and circuit area, and sensitivity-penalties might be incurred as well. Furthermore, the required frequency synthesizers for the multiple DCRXs would be required to operate very close to one another in the frequency plane, resulting in possible interference effects occurring.

Another technique would use a wideband RF receive filter, in combination with a single analog mixer and IQ mixing that would occur after the ADC. The wideband filter should be expected to provide rejection for alternate channels and in-band blockers outside of the sub-carrier frequency group or "bunch" of interest. Thus, the attenuation for these signals must be sufficient to not exceed the dynamic requirements of the ADC. This implies that many high order and very high Q filters would be required (if the wideband filter is not tunable). While the use of an image rejection mixer should provide some assistance in rejecting interfering channels, this approach is impractical from at least a cost-effective implementation perspective.

Another approach to implementing a multi-carrier receiver employs an analog IQ mixer pair with a complex (as opposed to real) analog wideband filter, and with final IQ detection after the ADC. However, it can be shown that IQ-imbalances on the analog side of the receiver restrict the image rejection to about 30dB, when about twice as much image rejection may be needed. Further reference with regard to this approach can be had to U.S. Patent No.: 4,914,408.

Still another approach to implementing a multi-carrier receiver is to employ an analog IQ mixer pair with a real (as opposed to complex) analog wideband (bandpass) filter and image rejection digitally, in combination with IQ detection after the ADC. In this case the IQ mixer pair mixes the sub-carrier bunch to an IF, and analog filters in the I and Q channels are then used to separate the sub-carriers and their images from other interfering signals. However, in this approach the dynamic requirements of the ADC become too stringent to provide a cost-effective implementation.

Various related prior art techniques can be found in U.S. Patent No.: 4,241,451, "Single Sideband Signal Demodulator", by R. Maixner et al.; U.S. Patent No.: 4,220,818, "AM Stereo Transmitter", by L. Kahn; U.S. Patent No.: 6,081,697, "Multi-Carrier Radio System and Radio Transceiver Implementation", by J. Haartsen; EP938208A1, "Multicarrier Transmission, Compatible with the Existing GSM System", by R. Boehnke et al.; and EP715403A1, "A Satellite Tuner Stage", by J. James.

A point that should be kept in mind is that none of these conventional approaches exhibit the desirable property of providing a high synergy with the single carrier receiver architecture. This is an important consideration, as when in the voice operation mode most GSM receivers are in a DCRX mode, and thus switching to multi-carrier reception (data mode) and back should occur as simply as possible.

It can thus be appreciated that an unfulfilled need exists to provide a multi-carrier receiver that overcomes the foregoing and other problems.

### OBJECTS AND ADVANTAGES OF THE INVENTION:

It is a first object and advantage of this invention to provide an improved multi-carrier receiver.

It is a further object and advantage of this invention to provide an improved multi-carrier receiver for use in a mobile station that overcomes the foregoing and other problems, that is cost effective to implement, and that is synergistic with the use of a DCRX in a single carrier reception environment.

### SUMMARY OF THE INVENTION

The foregoing and other problems are overcome and the foregoing objects and advantages are realized by methods and apparatus in accordance with embodiments of this invention.

In accordance with a method for multi-carrier reception, the following steps are executed: downconverting a received RF signal to in-phase (I) and quadrature (Q) channel signals each containing a plurality of sub-carriers at a low intermediate frequency (low-IF) and, if required, one sub-carrier or a single carrier centered around 0 Hz; filtering interfering signals outside of a frequency band of interest with analog lowpass filters in the I and Q channels; converting the I and Q channel signals to digital representations thereof; in the multi-carrier reception case, separating sub-carriers that are images of one another by quadrature downmixing the digital representations of the I and Q channel signals to baseband in the digital domain; and digitally adding or subtracting resulting I and Q signals to obtain one or both of an upper sideband and a lower sideband containing desired ones of the multi-carriers. For a symmetric multi-carrier reception case the step of downconverting includes a step of tuning a local oscillator to a center frequency of a group of sub-carriers, while for an asymmetric multi-carrier reception case the step of downconverting includes a step of tuning a local oscillator between a middlemost sub-carrier and its interfering adjacent channel.

In the multi-carrier operation case a wideband analog lowpass filter is replaced by narrower filters whose bandwidths are set by the bandwidth of the individual sub-carriers, and whose center frequencies are one of fixed or tunable.

In the single carrier reception case the receiver operates either in a direct conversion or a low-IF mode, and changing from multi-carrier reception to single carrier reception executes steps of tuning an analog baseband filter bandwidth to account for the single carrier bandwidth, adjusting an analog to digital converter bandwidth and dynamic range single carrier reception, and wherein digital quadrature downmixing and digital adders may be reconfigured or deactivated.

In the single carrier reception case the receiver operates in an IF mode, and wherein changing from single carrier to multi-carrier reception executes steps of bypassing an IF-filter, tuning an analog baseband filter bandwidth to account for the multi-carrier signal bandwidth, adjusting an analog to digital converter bandwidth and dynamic range for multi-carrier reception, and where digital quadrature downmixing and digital adders are activated.

After analog to digital conversion the amplitude and phase imbalances between I and Q channels are compensated to maximize unwanted sideband suppression.

In the multi-carrier reception case the receiver gain in analog circuitry is adjusted based on the power of all sub-carriers, or if the sub-carrier spacing is sufficiently small, is based on the power of the sub-carrier's power.
In accordance with these teachings, digital filtering provides a final selectivity for each of the sub-carriers.

Selective filtering in the analog domain may be implemented by either lowpass filtering with a sufficiently wide bandwidth so as to cover an entire sub-carrier bunch or, alternatively, each sub-carrier may have its own associated narrowband filter in order to relax the dynamic requirement of the analog to digital conversion function, as compared to the lowpass filter case.

The disclosed multi-carrier reception method and apparatus has a highest synergy with the conventional single carrier DCRX approach.

### BRIEF DESCRIPTION OF THE DRAWINGS

The above set forth and other features of the invention are made more apparent in the ensuing Detailed Description of the Invention when read in conjunction with the attached Drawings, wherein:
Fig. 1 is a simplified block diagram of a wireless communication system that is suitable for practicing this invention;
Fig. 2 is a frequency diagram that is useful in explaining the operation of the multi-carrier receiver, and shows a symmetrical multi-carrier group or bunch at the input to a receiver ADC;
Fig. 3 is a block diagram of a presently preferred embodiment of the mobile station receiver of Fig. 1 which, from a single sub-carrier point of view, is capable of multi-carrier reception and the digital cancellation of image frequencies;
Fig. 4 is a block diagram that depicts post-ADC carrier selection logic in accordance with an aspect of these teachings;
Fig. 5 is a frequency diagram that is useful in explaining an asymmetric sub-carrier selection process, and shows a asymmetrical multi-carrier group or bunch at the input to the receiver ADC;
Fig. 6 is a block diagram that depicts the post-ADC carrier selection logic as in Fig. 4, and that further illustrates digital logic that compensates amplitude and phase imbalances between the digital I and Q signals;
Fig. 7 shows in greater detail the power measurement and digital gain control aspects of Fig. 3; and
Fig. 8 illustrates a technique for bypassing a single carrier IF filter to provide a multi-carrier signal path.

### DETAILED DESCRIPTION OF THE INVENTION

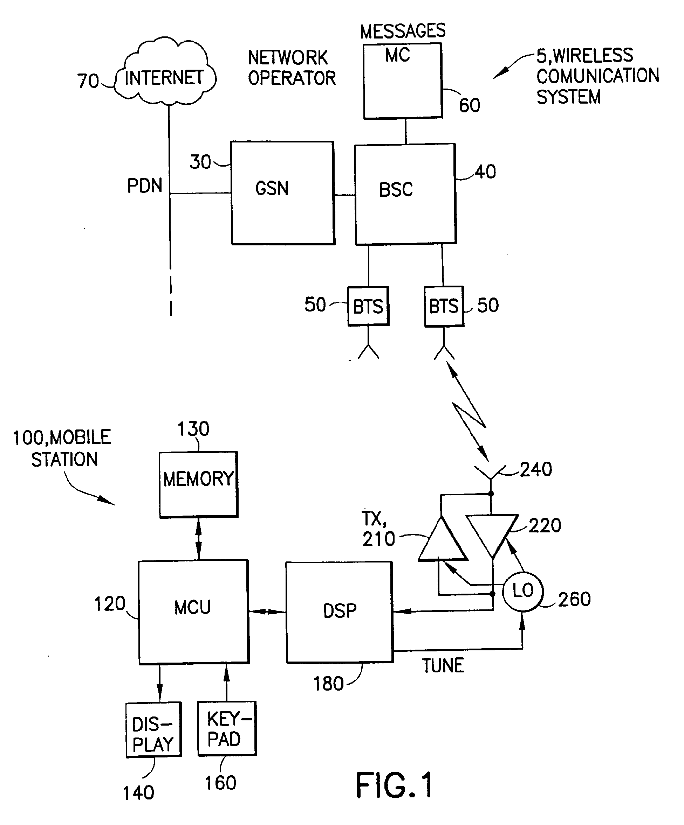

Referring first to Fig. 1, there is illustrated a simplified block diagram of an embodiment of a wireless communications system 5 that is suitable for practicing this invention. The wireless communications system 5 includes at least one mobile station (MS) 100. Fig. 1 also shows an exemplary network operator having, for example, a GPRS Support Node (GSN) 30 for connecting to a telecommunications network, such as a Public Packet Data Network or PDN, at least one base station controller (BSC) 40, and a plurality of base transceiver stations (BTS) 50 that transmit in a forward or downlink direction both physical and logical channels to the mobile station 100 in accordance with a predetermined air interface standard. A reverse or uplink communication path also exists from the mobile station 100 to the network operator, which conveys mobile originated access requests and traffic. It is assumed for the purposes of this invention that the BTS 50 has multi-carrier transmission capability.

In a preferred, but not limiting, embodiment of these teachings, the air interface standard can conform to any standard that enables multi-carrier data transmissions to occur to the mobile station 100, such as data transmissions enabling Internet 70 access and web page downloads. In the presently preferred embodiment of this invention the air interface standard is a Time Division Multiple Access (TDMA) air interface that supports a GSM or an advanced GSM protocol and air interface, although these teachings are not intended to be limited to TDMA or to GSM or GSM-related wireless systems.

The network operator may also include a suitable type of Message Center (MC) 60 that receives and forwards messages for the mobile stations 100. Other types of messaging service may include Supplementary Data Services and one under currently development and known as Multimedia Messaging Service (MMS), wherein image messages, video messages, audio messages, text messages, executables and the like, and combinations thereof, can be transferred between the network and the mobile station 100.

The mobile station 100 typically includes a microcontrol unit (MCU) 120 having an output coupled to an input of a display 140 and an input coupled to an output of a keyboard or keypad 160. The mobile station 100 may be a handheld radiotelephone, such as a cellular telephone or a personal communicator. The mobile station 100 could also be contained within a card or module that is connected during use to another device. For example, the mobile station 10 could be contained within a PCMCIA or similar type of card or module that is installed during use within a portable data processor, such as a laptop or notebook computer, or even a computer that is wearable by the user.

The MCU 120 is assumed to include or be coupled to some type of a memory 130, including a read-only memory (ROM) for storing an operating program, as well as a random access memory (RAM) for temporarily storing required data, scratchpad memory, received packet data, packet data to be transmitted, and the like. A separate, removable SIM (not shown) can be provided as well, the SIM storing, for example, a preferred Public Land Mobile Network (PLMN) list and other subscriber-related information. The ROM is assumed, for the purposes of this invention, to store a program enabling the MCU 120 to execute the software routines, layers and protocols required to implement at least the reception of data using a multi-carrier approach in accordance with the teachings herein, as well as to provide a suitable user interface (UI), via display 140 and keypad 160, with a user. Although not shown, a microphone and speaker are typically provided for enabling the user to conduct voice calls in a conventional manner.

The mobile station 100 also contains a wireless section that includes a digital signal processor (DSP) 180, or equivalent high speed processor or logic, as well as a wireless transceiver that includes a transmitter 200 and a receiver 220, both of which are coupled to an antenna 240 for communication with the network operator. At least one local oscillator (LO) 260, such as a frequency synthesizer, is provided for tuning the transceiver. Data, such as packet data, is transmitted and received through the antenna 240. The following discussion pertains most particularly to the receiver 220, assumed herein to be a DCRX receiver, as well as to the operation of the DSP 180 in implementing the presently preferred embodiment of the DCRX multi-carrier receiver in accordance with these teachings.

By way of introduction, the teachings of this invention relate to a combination of DCRX and low intermediate frequency (low-IF) receiver radio architectures where the IF of a certain subcarrier is defined by sub-carrier separation in the frequency plane. In the low-IF case the IF is assumed to be non-zero, and to have a value where no separate analog IF filter is required. From the perspective of an entire sub-carrier bunch, the receiver operates as a conventional DCRX and mixes the group of sub-carriers around 0 Hz (zero Hertz). In practice, if there are an odd number of sub-carriers the receiver operates as a DCRX for the middlemost sub-carrier (in the symmetric case.) The teachings of this invention do not impose any requirement as to the location of the multiple carriers in the frequency domain, or on the number of multiple carriers. Consequently, these teachings support both asymmetric and symmetric operation. An important aspect of these teachings is a configuration of single carrier DCRX for multi-carrier reception with minimal modifications, and with optimal performance in current consumption and cost effectiveness.

In symmetric operation, the local oscillator 260 is tuned to the center frequency of the sub-carrier group or "bunch" (of frequencies), and an in-phase (I) and a quadrature (Q) signal are generated in an IQ mixer. Consequently, sub-carriers at the low-IF act as images of one another. The separation of the sub-carriers that are images of one another is accomplished by quadrature downmixing to baseband in the digital domain, and by adding or subtracting I and Q signals to obtain the desired upper or lower sideband. In the symmetric case both the upper and lower sideband of the low-IF signals are detected, with proper selections of the summing operators. Depending on the actual multi-carrier deployment there may be a need for bandpass filters with a tunable center frequency at the low-IF, before the ADC, in order to alleviate the dynamic range requirement of the ADC. However, the presently preferred operational mode is to provide a single lowpass filter before the analog to digital conversion function. This is possible if there are no strong interfering signals in between the sub-carriers, and if the sub-carriers are located symmetrically in the frequency plane. For the case of an odd number of sub-carriers in the symmetric operation, the middle carrier is downconverted directly to baseband (in the analog circuitry).

In asymmetric operation the receiver LO 260 is not tuned to the center frequency of the sub-carrier bunch, but is tuned instead between a middlemost subcarrier and that sub-carrier's interfering adjacent channel. This is done in order to alleviate image rejection requirements. This type of operation may be desirable if adjacent channels are at a lower level compared to the desired signals, and if the modulation scheme employed requires a high signal-to-noise ratio (SNR).

Negative frequencies are not mirrored to the real side if quadrature downconversion is used (actually they are to some extent, but are heavily suppressed). The basic idea behind this well-known concept is that the phase relation between the I and Q signals is different for the desired or wanted signal (+90°, i.e., positive frequencies) and the mirror signal (-90°, i.e., negative frequencies), which makes possible the discrimination between these two signals.

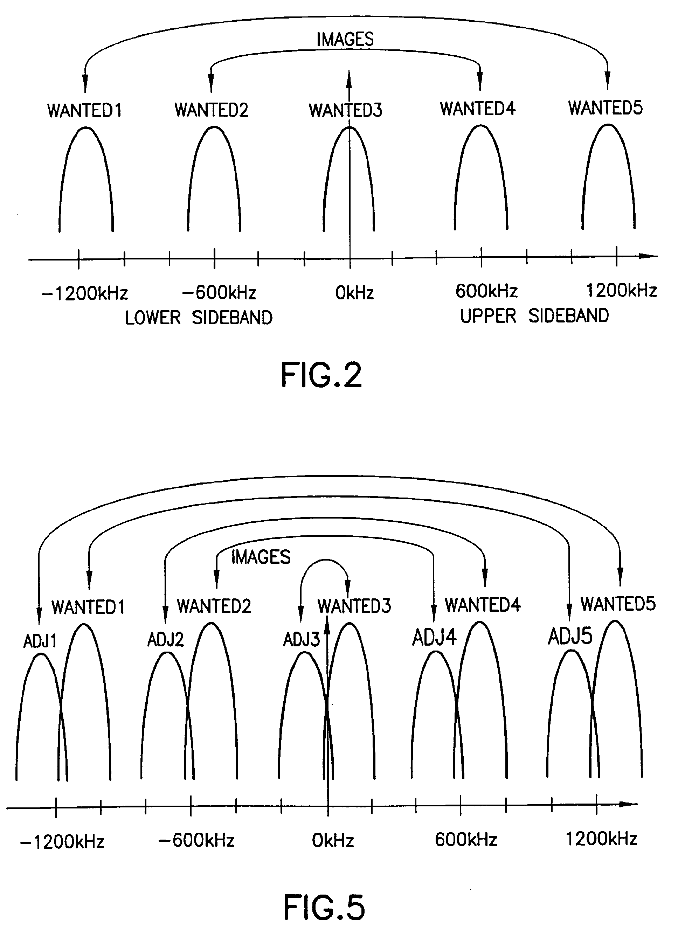

A sub-carrier bunch is mixed around DC in a quadrature analog mixer pair. The resulting downmixed sub-carriers, with an exemplary 600kHz carrier separation, are shown in Fig. 2 (which assumes the symmetrical case). As can be seen, the desired or wanted sub-carriers 1 and 5, as well as the wanted sub-carriers 2 and 4, are image pairs. The wanted 3 image is suppressed during the analog IQ mixing (DCRX operation).

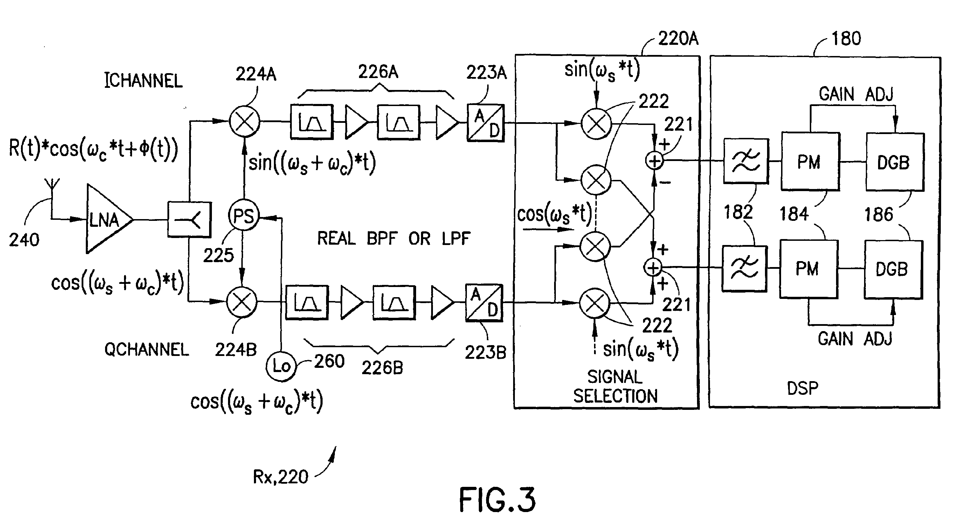

Fig. 3 is a circuit diagram of the image rejection receiver 220. In general, Fig. 3 presents the basic concept of cancelling the image frequencies in a digital manner. The receiver 220 has an input coupled to the antenna 240 and an output coupled to the DSP 180, as was generally shown in Fig. 1. A signal selection block 220A in Fig. 3 may be implemented by either the DSP 180 or by digital logic. Referring to both Fig. 2 and Fig. 3, if wanted 2 and wanted 4 are at the antenna 240, the output of the DSP 180 is the data in wanted 4. With other types of sign configurations of adder 221 the output would be the data in wanted 2. In the presently preferred embodiment the receiver 220 includes at least the one signal selection block 220A containing adders 221 that are fed by digital multipliers 222. The digital multipliers 222 receive their inputs from I channel and Q channel ADCs 223A and 223B, respectively. The I and Q channels are derived by splitting the received RF signal and applying the split signal to an I channel downconverter 224A and to a Q channel downconverter 224B. Downconverters 224A and 224B are driven from the LO 260 and through a phase shifter 225. Downconverter mixers 224A and 224B are followed by a baseband (BB) filter implemented as a real bandpass filter (BPF) or a low pass filter (LPF) 226A and 226B, respectively. It is the downconverted and filtered I channel and Q channel signals that are applied to the ADCs 223A and 223B for conversion to the digital domain and further processing.

In general, the decision as to whether a signal appearing on the negative or the positive frequency image pair is to be selected is made in the pair of adders 221 located just before the DSP 180. In Fig. 3 the adder 221 configuration is such that the signal on the positive frequencies is selected while the image on the negative frequencies is attenuated. Another configuration of plus and minus inputs to the adders 221 would result in a cancellation or attenuation of the signal on the positive frequencies and the selection of the signal on the negative frequencies, as was mentioned above.

It is thus straightforward to obtain both: e.g., sub-carriers wanted 1 and wanted 5 have common multipliers 222 but separate adders 221, where one adder pair selects wanted 1 and suppresses wanted 5, while the other selects wanted 5 and suppresses wanted 1.

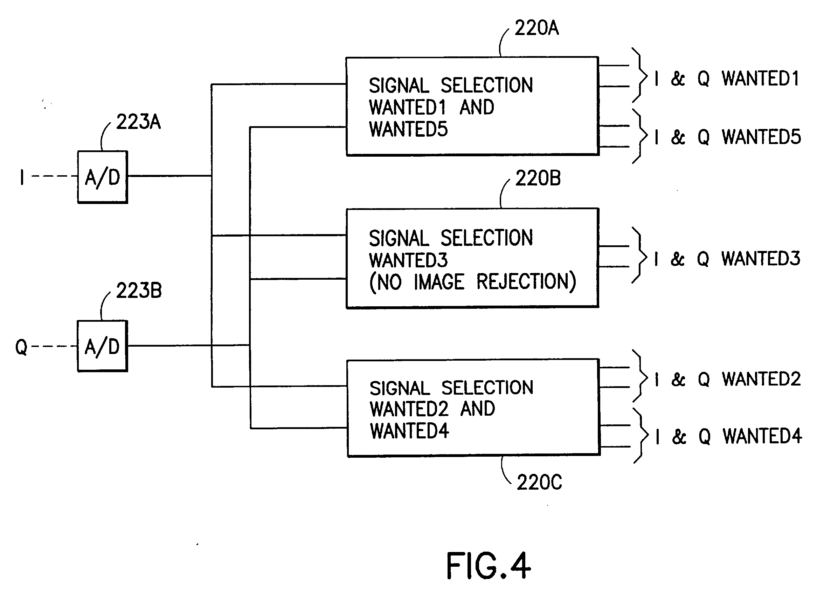

The foregoing operation of the receiver 220 in accordance with these teachings is shown in Fig. 4, wherein multiple signal selection blocks 220A, 220B, 220C are provided. Since all sub-carriers are assumed to be equally powered, the image rejection requirement remains moderate.

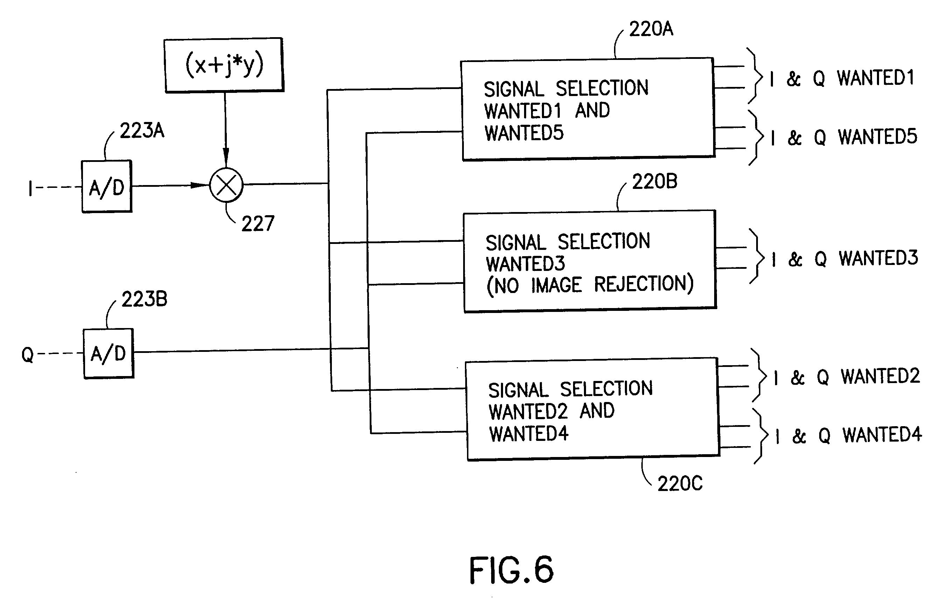

It is noted that there may be digital IQ tuning before the signal selection block 220A to improve the image rejection. This is shown in Fig. 6, where digital logic 227 changes the phase and amplitude of the I (or Q) signal relative to Q (or I) using values for x and y that are read from the memory 130. These values may be stored in the memory 130 during a production tuning phase.

The purpose of the IQ tuning is to compensate phase and/or amplitude imbalances generated in the analog circuitry, and to thus improve the image rejection. The compensation may be done, e.g., during production testing where the level of the unwanted sideband is compared to the wanted sideband, and which may be measured using certain tuning parameter values which are read from memory. The parameter values giving the highest unwanted sideband suppression are then selected for use and are stored in the memory 130..

Assume now as an example that a downlink multi-carrier transmission as shown in Fig. 2 is activated by the network (for example, the mobile station 100 changes from a voice call to a data call.) The procedure for receiving the multi-carriers by the mobile station 100 is then as follows:

### Procedure:

(A) The baseband (BB) lowpass filter 226A, 226B bandwidth is increased from 100kHz to 1.3MHz. Note that since the sub-carrier bunch is located around 0Hz, the lowpass filter comer frequency is thus around 1.3MHz. Since this filter is real (not complex), it covers all five sub-carriers.
(B) The oversampling ratios of the I and Q branch ADCs 223A, 223B are increased to achieve sufficient dynamic range over the 1.3MHz bandwidth, or depending on ADC topology used, some other technique can be used for increasing the dynamic range.
(C) The synthesizer (LO 260) frequency is settled to the middle frequency of the sub-carrier frequency group or bunch if it differs from the single carrier operation frequency. (note that there may be only two, three or four sub-carriers with different frequency separation)
(D) The signal paths after the ADCs 223A, 223B are changed according to Fig. 4. Each image pair thus goes to the same signal selection block 220A, 220B 220C, as shown in Fig. 3, where four multipliers 222 convert the signals to baseband, after which four adders 221 (two for each subcarrier) select the lower or the upper sideband.
(E) Next, any further processing is provided by the DSP 180, e.g., the application of digital automatic gain control (AGC).

Further with regard to the DSP 180, and still referring to Fig. 3, digital low pass filters 182 may be provided to achieve final selectivity for each of the sub-carriers. The DSP 180 may also implement digital power measurement (PM) logic 184 for measuring power in all sub-carriers when operating with multi-carrier reception. Also in this case, a digital gain block (DGB) 186 can be provided for independently adjusting the sub-carrier power based on the measured power from blocks 186.

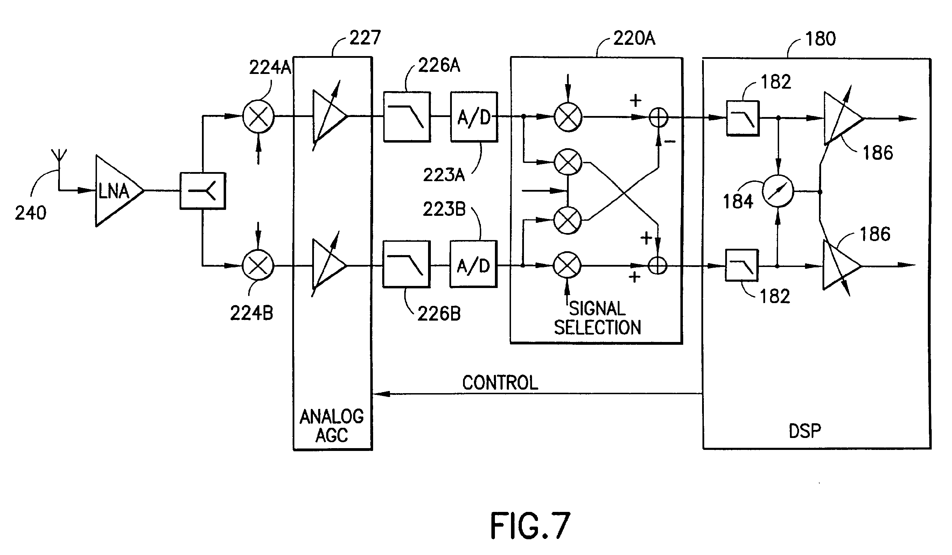

Fig. 7 shows in greater detail the power measurement and digital gain control aspects of Fig. 3, and also illustrates an analog AGC block 227 that is interposed between mixers 224A, 224B and the low pass filters 226A and 226B. Note that in some embodiments it may be desirable to provide decimation between the low pass filters 182 and the power measurement block 184.

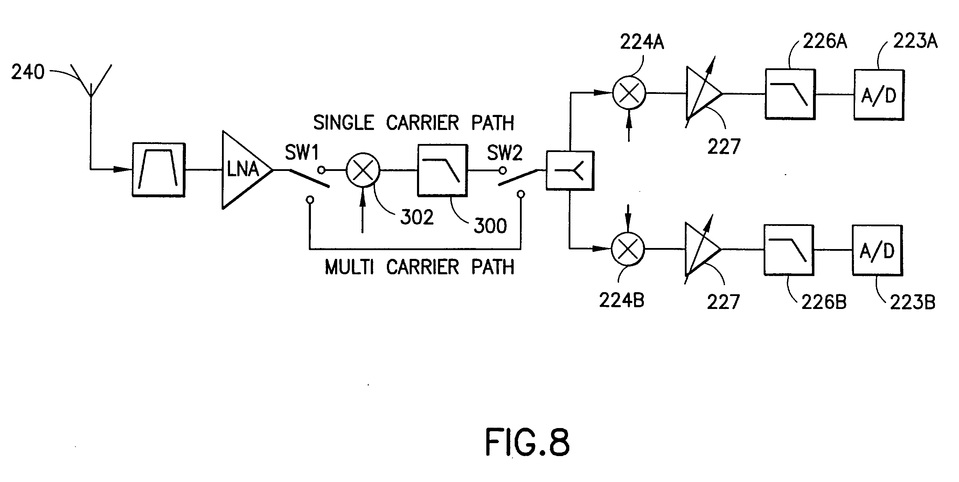

Fig. 8 illustrates a technique for bypassing a single carrier IF filter 300, if present, to provide a multi-carrier signal path. Note that it is assumed that the GSM receiver is the DCRX type, however some implementations may provide the IF filter 300, and mixer 302, mainly due to problems experienced with DC-offset. In this case a switch network (SW1, SW2) can be provided to bypass the single-carrier IF mixer 302 and the IF filter 300. If the multi-carrier operation does not have a sub-carrier around 0 Hz, no DC-offset problem exists in the multi-carrier mode. The illustrated circuitry may be utilized so long as the IQ mixer pair 224A, 224B does not contain reactive components (i.e., have a narrow bandwidth).

As was mentioned above, certain modulation schemes require a high signal-to-noise ratio (SNR), for example, one known as a Multiple Coding Scheme (MCS) class 9 in EGPRS, actually MCS-9, requires a SNR of almost 30dB. As a result, if there are two equal powered MCS-9 sub-carriers as an image pair, then about 45dB of image rejection is required. While the presently preferred embodiment of this invention employs symmetric reception in combination with IQ tuning (see Fig. 6), if the required image rejection cannot be achieved by additional IQ tuning, the sub-carriers may be arranged asymmetrically at the ADC 223 input. This is illustrated in Fig. 5, where the sub-carrier wanted3 IF is 100 kHz instead of 0kHz, implying that its adjacent channel (adj3) acts as the image. This relaxes the MCS-9 image rejection requirement to about 30dB. Note that as mentioned previously, a similar image rejection in dB is achieved also for the alternate channel of wanted1, which images to the adjacent channel of wanted5. Asymmetric operation would also provide certain other benefits, such as an absence of DC-offset problems.

The use of the teachings of this invention provide a number of advantages. For example, the image frequency rejection requirements remain moderate when the image is at the same level as the wanted signal (symmetric case). Note that, by example, the MCS-9 mode in EGPRS requires such a high SNR that in the standard requirements the adjacent channel is actually at a lower level than the wanted channel. Thus, from the image rejection point of view, it would be beneficial to have the adjacent channel as the image instead of the wanted channel. A procedure for accomplishing this was described above in relation to Fig. 5 (asymmetric case).

Furthermore, the digital implementation employed by these teachings are less sensitive to IQ imbalances. Also, the use of IQ tuning as in Fig. 6 becomes possible to increase the image rejection.

The digital implementation of the image rejection function furthermore provides rejection for all images, i.e., also for those that would image not only to the wanted channel(s) but also to adjacent channels. This is not the case when using, for example, an image rejection mixer.

The teachings of this invention can be implemented by increasing the baseband bandwidth, including the bandwidth of the ADCs 223A, 223B and employing the correct mathematical operations in digital circuitry (such as the DSP 180), as compared to the currently specified GSM receiver.

Relatedly, the ADC 223 bandwidth is effectively halved as compared to some of the other multi-carrier methods that were summarized above, as the signals of interest are located around DC, not around some IF. Also, the lower the IF the easier it becomes to achieve the high dynamic ADC implementation. Furthermore, and as was mentioned, the IQ tuning of Fig. 6 may be performed before the signal selection block in order to improve image rejection.

While described primarily in the context of multi-carrier reception by the mobile station 100, it should be appreciated that the teachings of this invention could be implemented as well on the network side (e.g., in the BTS 50), if the mobile station 100 has multi-carrier transmission capability.

Thus, while the invention has been particularly shown and described with respect to preferred embodiments thereof, it will be understood by those skilled in the art that changes in form and details may be made therein without departing from the scope and spirit of the invention.

## Claims

1. A method for performing both single-carrier and multi-carrier reception, comprising steps of:
downconverting received RF signals to in-phase (I) and quadrature (Q) channel signals each comprising a plurality of sub-carriers at a low intermediate frequency (low-IF) and, if required, one sub-carrier or a single carrier centered around 0 Hz;
filtering interfering signals outside of a frequency band of interest with analog filters in the I and Q channels;
converting the I and Q channel signals to digital representations thereof;
in the multi-carrier reception case, separating sub-carriers that are images of one another by quadrature downmixing the digital representations of the I and Q channel signals to baseband in the digital domain; and
digitally adding or subtracting resulting I and Q signals to obtain one or both of an upper sideband and a lower sideband containing desired ones of the sub-carriers.

2. A method as in claim 1, wherein for a symmetric multi-carrier reception case the step of downconverting includes a step of tuning a local oscillator to a center frequency of a group of sub-carriers.

3. A method as in claim 1, wherein for an asymmetric multi-carrier reception case the step of downconverting includes a step of tuning a local oscillator between a middlemost sub-carrier and its interfering adjacent channel.

4. A method as in claim 1, wherein digital filtering provides a final selectivity for each of the sub-carriers.

5. A method as in claim 1, wherein in the multi-carrier operation case a wideband analog lowpass filter is replaced by narrower filters having bandwidths set by the bandwidth of the individual sub-carriers, and whose center frequencies are one of fixed or tunable.

6. A method as in claim 1, wherein in the single carrier reception case the receiver works either in a direct conversion or a low-IF mode, and changing from multi-carrier reception to single carrier reception comprises steps of tuning an analog baseband filter bandwidth to account for the single carrier bandwidth, adjusting an analog-to-digital converter bandwidth and dynamic range for single carrier reception, and wherein digital quadrature downmixing and digital adders may be reconfigurated or deactivated.

7. A method as in claim 1, wherein in the single carrier reception case the receiver operates in an IF mode, and wherein changing from single carrier to multi-carrier reception comprises steps of bypassing an RF mixer and an IF-filter, tuning an analog baseband filter bandwidth to account for the multi-carrier signal bandwidth, adjusting an analog-to-digital converter bandwidth and dynamic range for multi-carrier reception, and where digital quadrature downmixing and digital adders are activated.

8. A method as in claim 1, wherein after analog-to-digital conversion the amplitude and phase imbalances between I and Q channels are compensated to maximize unwanted sideband suppression.

9. A method as in claim I, wherein in the multi-carrier reception case the receiver gain in analog circuitry is adjusted based on the power of all sub-carriers, or if the sub-carrier spacing is sufficiently small, is based on the power of one of the sub-carriers.

10. A method as in claim 1, wherein in the multi-carrier reception case the receiver gain in digital circuitry is adjusted separately for each sub-carrier, or if the sub-carrier spacing is sufficiently small, all sub-carriers are provided the same digital gain.

11. A receiver for single-carrier and multi-carrier reception, comprising:
downconverter circuitry for downconverting received RF signals to in-phase (I) and quadrature (Q) channel signals each comprising a plurality of sub-carriers at a low intermediate frequency (low-IF) and, if required, one sub-carrier or a single carrier centered around 0 Hz;
analog low pass filters with tunable corner frequencies for filtering interfering signals outside of a frequency band of interest in the I and Q channels;
I and Q channel analog-to-digital converters for converting I and Q channel signals to digital representations thereof;
I and Q channel quadrature downmixers for separating sub-carriers that are images of one another by quadrature downmixing the digital representations of the I and Q channel signals to baseband in the digital domain; and
digital adder logic for selectively adding or subtracting resulting I and Q signals to obtain one or both of an upper sideband and a lower sideband containing desired ones of the sub-carriers.

12. A receiver as in claim 11, wherein for a symmetric multi-carrier reception case said downconverter circuitry is operated by tuning a local oscillator to a center frequency of a group of sub-carriers.

13. A receiver as in claim 11, wherein for an asymmetric multi-carrier reception case said downconverter circuitry is operated by tuning a local oscillator between a middlemost sub-carrier and its interfering adjacent channel.

14. A receiver as in claim 11, wherein for a multi-carrier reception case said analog lowpass filters are each replaced by at least one narrower bandwidth filter whose bandwidth is set by the bandwidth of the individual sub-carriers and whose center frequency is one of fixed or tunable.

15. A receiver as in claim 11, wherein to accommodate both single-carrier and multi-carrier reception, the corner frequency of said analog lowpass filter and the bandwidth and dynamic range of said analog-to-digital converter are adjustable, and said digital downmixing and adder logic is deactivated when not needed.

16. A receiver as in claim 11, wherein to accommodate both single-carrier and multi-carrier reception, said receiver further comprises a switch structure for bypassing an RF mixer and an IF filter used for single carrier reception.

17. A receiver as in claim 11, and further comprising digital logic which compensates amplitude and phase imbalances between the digital I and Q signals.

18. A receiver as in claim 11, and further comprising digital logic for measuring sub-carrier power in the multi-carrier reception case.

19. A receiver as in claim 11, wherein in the multi-carrier reception case said receiver further comprises, for each sub-carrier, a digital gain block for independently adjusting sub-carrier power.

20. A mobile station, comprising a receive antenna and a digital signal processor (DSP), said mobile station further comprising a receiver having an input coupled to said antenna and an output coupled to an input of said DSP, said receiver being capable of multi-carrier reception and comprising:
downconverter circuitry for downconverting received RF signals to in-phase (I) and quadrature (Q) channel signals each comprising a plurality of sub-carriers at a low intermediate frequency (low-IF) and, if required, one sub-carrier or a single carrier centered around 0 Hz;
analog low pass filters having tunable corner frequencies for filtering interfering signals outside of a frequency band of interest in the I and Q channels;
I and Q channel analog-to-digital converters for converting I and Q channel signals to digital representations thereof;
I and Q channel quadrature downmixers for separating sub-carriers that are images of one another by quadrature downmixing the digital representations of the I and Q channel signals to baseband in the digital domain; and
digital adder logic for selectively adding or subtracting resulting I and Q signals to obtain one or both of an upper sideband and a lower sideband containing desired ones of the sub-carriers.

21. A mobile station receiver as in claim 20, wherein for a symmetric multi-carrier reception case said downconverter circuitry is operated by tuning a local oscillator to a center frequency of a group of sub-carriers.

22. A mobile station receiver as in claim 20, wherein for an asymmetric multi-carrier reception case said downconverter circuitry is operated by tuning a local oscillator between a middlemost sub-carrier and its interfering adjacent channel.

23. A mobile station receiver as in claim 20, wherein for a multi-carrier reception case said analog lowpass filters are each replaced by at least one narrower bandwidth filter whose bandwidth is set by the bandwidth of the individual sub-carriers and whose center frequency is one of fixed or tunable.

24. A mobile station receiver as in claim 20, wherein to accommodate both single-carrier and multi-carrier reception, the corner frequency of said analog lowpass filter and the bandwidth and dynamic range of said analog-to-digital converter are adjustable, and said digital downmixing and adder logic is deactivated when not needed.

25. A mobile station receiver as in claim 20, wherein to accommodate both single-carrier and multi-carrier reception, said receiver further comprises a switch structure for bypassing an RF mixer and an IF filter used for single carrier reception.

26. A mobile station receiver as in claim 20, and further comprising digital logic for compensating amplitude and phase imbalances between the digital I and Q signals.

27. A mobile station receiver as in claim 20, and further comprising digital logic for measuring power in all sub-carriers in the multi-carrier reception case.

28. A mobile station receiver as in claim 20, wherein in the multi-carrier reception case said receiver further comprises, for each sub-carrier, a digital gain block for independently adjusting sub-carrier power.

29. In a receiver used for single carrier reception, a method for performing multi-carrier reception, comprising steps of:
downconverting received RF signals to in-phase (I) and quadrature (Q) channel signals each comprising a plurality of sub-carriers at a low intermediate frequency (low-IF);
converting the I and Q channel signals to digital representations thereof;
separating sub-carriers that are images of one another by quadrature downmixing the digital representations of the I and Q channel signals to baseband in the digital domain; and
selectively adding or subtracting the resulting downmixed digital representations of the I and Q signals to obtain at least one of an upper sideband and a lower sideband containing desired ones of the sub-carriers.

30. A method as in claim 29, wherein the step of downconverting received RF signals also generates a sub-carrier centered at about 0 Hz.
